# EUROPEAN PATENT APPLICATION

(11) **EP 3 691 415 A1**
(43) Date of publication of application: **05.08.2020**
(21) Application number: 18861664.3
(22) Date of filing: 28.09.2018
(51) Int. Cl.: H05B 33/10, H01L 51/50, H05B 33/04

(54) **METHOD FOR MANUFACTURING ORGANIC ELECTRONIC DEVICE**

(30) Priority: 28.09.2017 JP 2017188319
(71) Applicant: Sumitomo Chemical Company, Limited, Tokyo 104-8260 (JP); Ajinomoto Co., Inc., Tokyo 104-8315 (JP)
(72) Inventor: SHIMOGAWARA Masaya, Niihama-shi Ehime 792-0015 (JP); MORISHIMA Shinichi, Tsukuba-shi Ibaraki 300-3294 (JP); FUJII Takashi, Niihama-shi Ehime 792-0015 (JP); MASUYAMA Manabu, Kawasaki-shi Kanagawa 210-0801 (JP)
(74) Representative: J A Kemp LLP
(86) International application number: PCT/JP2018/036374
(87) International publication number: WO 2019/066005

(57) **Abstract**

A method for manufacturing an organic electronic device according to an embodiment includes: a device base material forming step of forming a device base material 40 in which a first electrode 42, an organic layer-containing device function part 43, and a second electrode 44 are sequentially provided on a substrate 41; a dehydration step of dehydrating a protective film-attached sealing member 10 in which a protective film 30 is layered, via an adhesive layer 22, on a sealing member 20 having the adhesive layer layered on a sealing base material 21; and a sealing member bonding step of bonding the sealing member via the adhesive layer to the device base material after the protective film is peeled from the protective film-attached sealing member having been subjected to the dehydration step, wherein the peel strength of the adhesive layer to the protective film in the protective film-attached sealing member is from 0.06 N/20 mm to 0.3 N/20 mm.

## Description

### Technical Field

The present invention relates to a method for manufacturing an organic electronic device.

### Background Art

Organic electronic devices have: a device base material in which a first electrode, a device function part (containing an organic layer), and a second electrode are mounted, in this order, on a substrate; and a sealing member for sealing the device function part. Sealing members, in which an adhesive layer (resin composition layer) is layered on a sealing base material (support), such as described in Patent Document 1, have been known. Such a sealing member is bonded via an adhesive layer to a device base material. In the technology described in Patent Literature 1, until the sealing member is bonded to the device base material, the adhesive layer of the sealing member is provided with a protective film (cover film). The sealing member is to prevent deterioration due to moisture in an organic layer of a device function part. Thus, it is preferable that the sealing member itself is dehydrated.

### Citation List

### Patent Literature

Patent Decument1: WO 2016/152756 A

### Summary of Invention

### Technical Problem

When a sealing member provide with a protective film (protective film-attached sealing member) is dehydrated, bubbling may occur, for instance, due to moisture release from an adhesive layer. Also, when the protective film is peeled from the adhesive layer, peeling marks (e.g., surface roughness) on the adhesive layer may occur.

Here, it is an object of the present invention to provide a method for manufacturing an organic electronic device in which bubbling during a step of dehydrating a protective film-attached sealing member is suppressed and peeling marks on an adhesive layer is unlikely to occur when the protective film is peeled from the adhesive layer.

### Solution to Problem

A method for manufacturing an organic electronic device according to an aspect of the invention includes: a device base material forming step of forming a device base material in which a first electrode, an organic layer-containing device function part, and a second electrode are sequentially provided on a substrate; a dehydration step of dehydrating a protective film-attached sealing member in which a protective film is layered, via an adhesive layer, on a sealing member having the adhesive layer layered on a sealing base material; and a sealing member bonding step of bonding the sealing member via the adhesive layer to the device base material after the protective film is peeled from the protective film-attached sealing member having been subjected to the dehydration step. The peel strength of the adhesive layer to the protective film in the protective film-attached sealing member is from 0.06 N/20 mm to 0.3 N/20 mm.

When the peel strength of the adhesive layer to the protective film is within the above range, bubbling during the dehydration step can be suppressed and peeling marks on the adhesive layer are unlikely to occur when the protective film is peeled from the adhesive layer during the sealing member bonding step.

In the dehydration step, the protective film-attached sealing member may be irradiated with infrared radiation to dehydrate the protective film-attached sealing member. In this case, moisture can be directly heated by infrared radiation, so that dehydration can be carried out efficiently.

The adhesive layer may contain a desiccant. In this case, in the manufactured organic electronic device, moisture infiltration into the organic layer can be prevented further.

The thickness of the protective film may be 50 µm or less. In this case, the protective film-attached sealing member can be dehydrated efficiently.

In an embodiment, the thickness of the protective film may be equal to or more than7 µm and equal to or less than 25 µm, and the peel strength may be from 0.06 N/20 mm to 0.18 N/20 mm.

Examples of a material for the sealing base material include aluminum or copper. When the material for the sealing base material contains aluminum or copper and bubbles occur during the dehydration step, the sealing base material is vulnerable to deformation due to the influence of bubbling and/or peeling marks. Hence, the invention, where bubbles and peeling marks are unlikely to occur as described above, is more effective when the material for the sealing base material contains aluminum or copper.

### Advantageous Effects of Invention

The invention can provide a method for manufacturing an organic electronic device in which bubbling during a step of dehydrating a protective film-attached sealing member is suppressed and peeling marks on an adhesive layer are unlikely to occur when the protective film is peeled from the adhesive layer.

### Brief Description of Drawings

FIG. 1 is a side view of a protective film-attached sealing member according to an embodiment.
FIG. 2 is a flowchart illustrating a method for manufacturing an organic EL device (organic electronic device) using the protective film-attached sealing member shown in FIG. 1.
FIG. 3 is a cross-section view showing an example of the configuration of a device base material that an organic EL device to be manufactured has.
FIG. 4 is a diagram for illustrating a preparation step shown in FIG. 2.
FIG. 5 is a diagram for illustrating a sealing member bonding step in a method for manufacturing an organic EL device (organic electronic device).

### Description of Embodiments

Hereinbelow, embodiments of the invention will be described with reference to the drawings. The same elements have the same reference numerals so as to avoid redundant description. The size ratios in the drawings are not necessarily the same as those in the description.

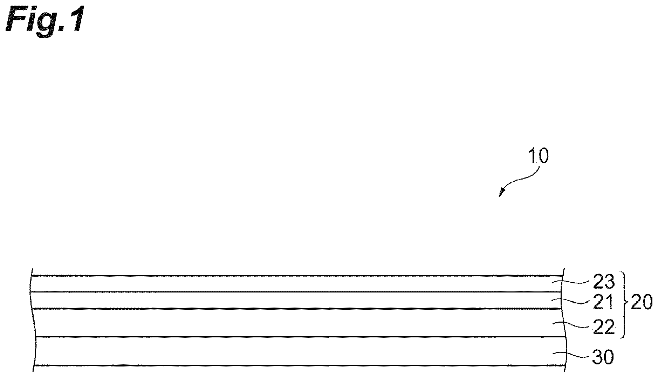

FIG. 1 is a side view of a protective film-attached sealing member 10 used for manufacturing an organic EL device (organic electronic device) according to an embodiment. FIG. 1 schematically illustrates the configuration of the protective film-attached sealing member 10. The protective film-attached sealing member 10 includes a sealing member 20 and a protective film 30. The protective film-attached sealing member 10 may have a belt shape or a sheet shape. Hereinafter, unless otherwise indicated, the protective film-attached sealing member 10 has a belt shape.

The sealing member 20 is a member for preventing deterioration of an organic layer included in the organic EL device. The sealing member 20 has a sealing base material 21, an adhesive layer 22, and a resin film 23.

The sealing base material 21 has a moisture barrier function. The moisture permeability of the sealing base material 21 is, for instance, 5 × 10⁻⁵ g/(m²·24 hr) under an environment at a temperature of 40°C and a humidity of 90% RH. The sealing base material 21 may have a gas barrier function. Examples of the sealing base material 21 include: a metal foil; a barrier film having a barrier function layer(s) on one side or both sides of a transparent plastic film; a thin film glass with flexibility; a film in which metal with barrier property is layered on a plastic film, or the like. The thickness of the sealing base material 21 is, for instance, from 10 µm to 300 µm. From the viewpoint of barrier property, as the metal foil material, copper, aluminum, or stainless steel is preferably included, or copper or aluminum is more preferably included. When the sealing base material 21 is metal foil, the thickness of the metal foil is preferably thicker from the viewpoint of pinhole suppression and is preferably from 10 µm to 50 µm in view of flexibility aspect.

The adhesive layer 22 is layered on one surface of the sealing base material 21. The adhesive layer 22 is a layer disposed for bonding at least two adjacent layers to each other. The adhesive layer 22 has a thickness making it possible to embed a portion to be sealed with the sealing member 20 in the organic EL device. The thickness of the adhesive layer 22 is, for instance, from 5 µm to 100 µm.

Examples of a material for the adhesive layer 22 include a pressure-sensitive adhesive. Specifically, the adhesive layer 22 may be a sticky layer. Examples of the material for the adhesive layer 22 include a photocurable or thermosetting acrylate resin and a photocurable or thermosetting epoxy resin. It is also possible to use, as the adhesive layer 22, another common resin film that can be bonded using an impulse sealer, for instance, a thermal bonding film such as an ethylene-vinyl acetate copolymer (EVA), polypropylene (PP), polyethylene (PE), or polybutadiene film. A thermoplastic resin can also be used as the material for the adhesive layer 22. Examples of the thermoplastic resin include an olefin-based elastomer, a styrene-based elastomer, or a butadiene-based elastomer.

The adhesive layer 22 may contain a desiccant. The desiccant is a moisture absorbent. The desiccant may absorb, in addition to water, oxygen, etc. Examples of the desiccant include a metal oxide such as calcium oxide, magnesium oxide, strontium oxide, aluminum oxide, barium oxide, diphosphorus pentoxide, lithium oxide, sodium oxide, or the like. A metal oxide mixture, solid solution material, or the like may be used as the desiccant. Examples of the metal oxide mixture or solid solution material include calcined dolomite (a mixture containing calcium oxide and magnesium oxide), calcined hydrotalcite (a solid solution material of calcium oxide and aluminum oxide), or the like. Examples of a commercially available desiccant include calcined dolomite (e.g., "KT" manufactured by Yoshizawa Lime Industry CO., LTD.), calcium oxide (e.g., "Moistop #10" manufactured by SANKYO SEIFUN, Co., Ltd.), magnesium oxide (e.g., "KYOWAMAG MF-150" and "KYOWAMAG MF-30", manufactured by Kyowa Chemical Industry Co., Ltd., "PUREMAG FNMG" manufactured by Tateho Chemical Industries Co., Ltd.), lightly calcined magnesium oxide (e.g., "#500", "#1000", "#5000" manufactured by Tateho Chemical Industries Co., Ltd.), calcined hydrotalcite (e.g., "N41S" manufactured by TODA KOGYO CORP., "KW-2100" and "KW-2200" manufactured by Kyowa Chemical Industry Co., Ltd.), semi-calcined hydrotalcite (e.g., "DHT-4C" and "DHT-4A-2" manufactured by Kyowa Chemical Industry Co., Ltd.), or the like.

The resin film 23 is layered on the other surface of the sealing base material 21 (a surface on a side opposite to the surface in contact with the adhesive layer 22). Examples of a material for the resin film 23 include polyethylene terephthalate (PET), polyimide (PI), or the like. In FIG. 1, the sealing member 20 including the resin film 23 is shown as an example. However, as long as the sealing base material 21 and the adhesive layer 22 are included, the sealing member 20 is not necessarily provided with the resin film 23.

The protective film 30 is layered on a surface of the adhesive layer 22 on a side opposite to the surface in contact with the sealing base material 21. That is, the protective film 30 is layered via the adhesive layer 22 on the sealing member 20. The protective film 30 is a member for preventing dust from attaching to the adhesive layer 22, and for preventing the adhesive layer 22 from attaching to a conveying roll R described below, before the organic EL device is manufactured. The protective film 30 may be a peel film that can be peeled from the adhesive layer 22.

Examples of a material for the protective film 30 include polyethylene naphthalate (PEN), PET, PP, PE, PI, cycloolefin polymer, cycloolefin copolymer, or the like. The thickness of the protective film 30 is preferably 50 µm or less and is, for instance, from 7 µm to 50 µm.

Of the protective film 30, a surface in contact with the adhesive layer 22 may have a coating layer. Examples of a material for the coating layer include a silicone resin-based release agent, a fluorine-based release agent, an alkyd-based release agent, an acrylic release agent, or the like.

The peel strength of the adhesive layer 22 to the protective film 30 in the protective film-attached sealing member 10 is from 0.06 N/20 mm to 0.3 N/20 mm. The peel strength may be from 0.06 N/20 mm to 0.25 N/20 mm, further from 0.06 N/20 mm to 0.2 N/20 mm, and furthermore from 0.06 N/20 mm to 0.18 N/20 mm. The peel strength is 180-degree peel strength measured in accordance with JIS Z0237. The peel strength of the adhesive layer 22 to the protective film 30 may be adjusted by changing conditions (e.g., a temperature, a pressure) for bonding the protective film 30 to the adhesive layer 22. In an embodiment, where the protective film 30 surface in contact with the adhesive layer 22 has the above coating layer, the peel strength may be adjusted by changing the structure of material for the coating layer.

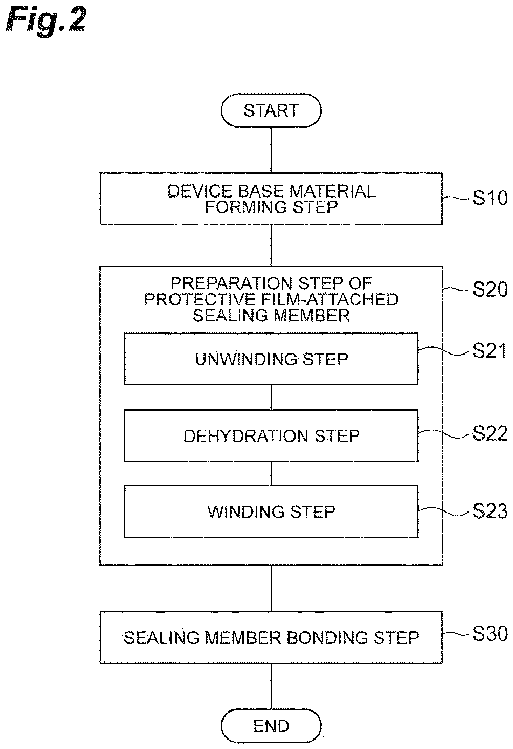

Next, an example of a method for manufacturing an organic EL device using the protective film-attached sealing member 10 shown in FIG. 1 will be described. As shown in FIG. 2, the method for manufacturing an organic EL device includes a device base material forming step S10, a preparation step S20 of the protective film-attached sealing member 10, and a sealing member bonding step S30. Unless otherwise indicated, the case where an organic EL device to be manufactured is a bottom emission type is described. However, the organic EL device may be a top emission type.

### [Device Base Material Forming Step]

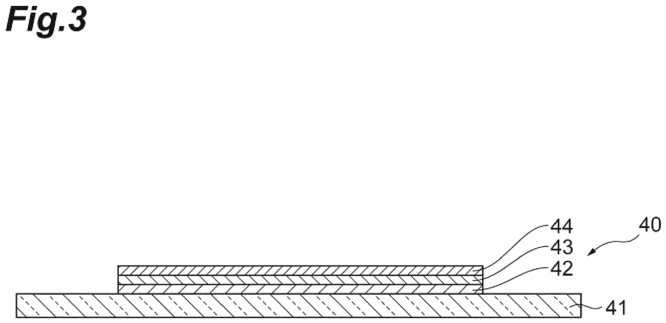

In the device base material forming step S10, as shown in FIG. 3, an anode (first electrode) 42, an organic EL part (organic layer-containing device function part) 43, and a cathode (second electrode) 44 are sequentially layered on a substrate 41 to form a device base material 40. The device base material 40 will be described.

### [Substrate]

The substrate 41 has transparency to light (including visible light at a wavelength of from 400 nm to 800 nm) that an organic EL device to be manufactured emits. In this embodiment, the substrate 41 used in manufacture of the organic EL device has a belt shape. The thickness of the substrate 41 is, for instance, from 30 µm to 700 µm.

The substrate 41 may have flexibility. Flexibility means that the substrate can be bent without shearing or rupturing when the predetermined force is applied to the substrate. The substrate 41 is, for instance, a plastic film or a polymer film. The substrate 41 may further have a barrier layer with a moisture barrier function. The barrier layer may have, in addition to the moisture barrier function, a gas (e.g., oxygen) barrier function.

### [Anode]

The anode 42 is disposed on the substrate 41. For the anode 42, a light transmittable electrode is used. As the light transmittable electrode, it is possible to use a highly electrically conductive thin film containing, for instance, a metal oxide, a metal sulfide, or a metal. A highly light transmittable thin film is preferably used. The anode 42 may have a network structure made of electric conductor (e.g., a metal). The thickness of the anode 42 may be determined in view of light transmittance, electric conductivity, and so on. The thickness of the anode 42 is usually from 10 nm to 10 µm, preferably from 20 nm to 1 µm, and more preferably from 50 nm to 500 nm.

Examples of a material for the anode 42 include indium oxide, zinc oxide, tin oxide, indium tin oxide (abbreviated as ITO), indium zinc oxide (abbreviated as IZO), gold, platinum, silver, copper, or the like. Among them, ITO, IZO, or tin oxide is preferable. The anode 42 may be formed as a thin film containing a material exemplified. As the material for the anode 42, it is possible to use organic matters such as polyaniline or a derivative thereof and polythiophene or a derivative thereof. In this case, the anode 42 may be formed as a transparent conductive film.

The anode 42 may be formed by, for instance, a dry film-formation method, a plating method, or a coating method. Examples of the dry film-formation method include vacuum evaporation, sputtering, ion plating, CVD, or the like. Examples of the coating method include inkjet printing, slit coating, micro-gravure coating, gravure coating, bar coating, roll coating, wire bar coating, spray coating, screen printing, flexographic printing, offset printing, nozzle printing, or the like. Among them, inkjet printing is preferable.

### [Organic EL Part]

The organic EL part 43 is a function part that contributes to light emission of an organic EL device, such as, movement of charges and recombination of charges, according to a voltage applied to the anode 42 and the cathode 44. The organic EL part 43 has an organic layer such as a light-emitting layer.

The light-emitting layer is a function layer with a light (including visible light)-emitting function. The light-emitting layer usually contains organic matter that primarily emits at least one of fluorescence or phosphorescence, or the organic matter and its aid dopant material. Thus, the light-emitting layer is an organic layer. The dopant material is added, for instance, to increase light emitting efficiency and modify an emission wavelength. The above organic matter may be a low-molecular-weight compound or a polymer compound. The thickness of the light-emitting layer is, for instance, from about 2 nm to 200 nm.

Examples of the organic matter that primarily emits at least one of fluorescence or phosphorescence include the following dye-based materials, metal complex-based materials, and polymer-based materials.

### (Dye-based Materials)

Examples of the dye-based materials include cyclopentamine derivatives, tetraphenyl butadiene derivative compounds, triphenylamine derivatives, oxadiazole derivatives, pyrazoloquinolin derivatives, distyrylbenzene derivatives, distyrylarylene derivatives, pyrrole derivatives, thiophene ring compounds, pyridine ring compounds, perinone derivatives, perylene derivatives, oligothiophene derivatives, an oxadiazole dimer, a pyrazoline dimer, quinacridone derivatives, coumarin derivatives, and the like.

### (Metal Complex-based Materials)

Examples of the metal complex-based materials include metal complexes having, as a center metal, for instance, a rare earth metal such as Tb, Eu or Dy, or Al, Zn, Be, Ir or Pt and having, as a ligand, for instance, an oxadiazole, thiadiazole, phenylpyridine, phenylbenzoimidazole, or quinoline structure. Examples of the metal complex-based materials include metal complexes, such as an iridium complex and a platinum complex, that can emit light from a triplet excited state, an aluminum quinolinol complex, a benzoquinolinol beryllium complex, a benzoxazolyl zinc complex, a benzothiazole zinc complex, an azomethyl zinc complex, a porphyrin zinc complex, a phenanthroline europium complex, and the like.

### (Polymer-based Materssials)

Examples of the polymer-based materials include polyparaphenylene vinylene derivatives, polythiophene derivatives, polyparaphenylene derivatives, polysilane derivatives, polyacetylene derivatives, polyfluorene derivatives, polyvinylcarbazole derivatives, those in which the above dye-based materials and/or metal complex-based light-emitting materials are each polymerized, and the like.

### (Dopant Materials)

Examples of the dopant material include perylene derivatives, coumarin derivatives, rubrene derivatives, quinacridone derivatives, squarylium derivatives, porphyrin derivatives, styryl-based pigments, tetracene derivatives, pyrazolone derivatives, decacyclene, phenoxazone, and the like.

The light-emitting layer may be formed by, for instance, a dry film-formation method or a coating method. Examples of the dry film-formation method or the coating method include the same ones as in the case of the anode 42. The light-emitting layer is preferably formed by inkjet printing.

The organic EL part 43 may have, in addition to the light-emitting layer, various function layers. Examples of the function layer(s) arranged between the anode 42 and the light-emitting layer include a hole injection layer and/or a hole transport layer. Examples of the function layer(s) arranged between the cathode 44 and the light-emitting layer include an electron injection layer and/or an electron transport layer. The electron injection layer may be part of the cathode 44. These function layers may each be an organic matter-containing organic layer.

Examples of the layer configuration of the organic EL part 43 are indicated below. In the following layer configuration examples, the anode and the cathode are also designated in parentheses so as to indicate the positional relationship among the anode 42, the cathode 44, and the respective function layer(s).
(a)(Anode)/light-emitting layer/(cathode)
(b)(Anode)/hole injection layer/light-emitting layer/(cathode)
(c)(Anode)/hole injection layer/light-emitting layer/electron injection layer/(cathode)
(d)(Anode)/hole injection layer/light-emitting layer/electron transport layer/electron injection layer/(cathode)
(e)(Anode)/hole injection layer/hole transport layer/light-emitting layer/(cathode)
(f)(Anode)/hole injection layer/hole transport layer/light-emitting layer/electron injection layer/(cathode)
(g)(Anode)/hole injection layer/hole transport layer/light-emitting layer/electron transport layer/electron injection layer/(cathode)
(h)(Anode)/light-emitting layer/electron injection layer/(cathode)
(i)(Anode)/light-emitting layer/electron transport layer/electron injection layer/(cathode)

The symbol "/" means that layers on the sides beside the symbol "/" are in contact with each other.

The hole injection layer is a function layer having a function of increasing efficiency of injecting holes from the anode to the light-emitting layer. The hole transport layer is a function layer having a function of increasing efficiency of injecting holes, to the light-emitting layer, from the anode, the hole injection layer, or a part of the hole transport layer close to the anode. The electron transport layer is a function layer having a function of increasing efficiency of injecting electrons, to the light-emitting layer, from the cathode, the electron injection layer, or a part of the electron transport layer close to the cathode. The electron injection layer is a function layer having a function of increasing efficiency of injecting electrons from the cathode to the light-emitting layer.

A known material can be used as a material for the function layer (e.g., hole injection layer, hole transport layer, electron injection layer, electron transport layer, and the like) other than the light-emitting layer that the organic EL part 43 has. The optimal value for the thickness of the function layer that the organic EL part 43 has is different depending on the material used and may be set in view of electric conductivity, durability, and so on. The function layer(s) other than the light-emitting layer that the organic EL part 43 has may also be formed by the methods similar to the methods of the light-emitting layer.

### [Cathode]

The cathode 44 is disposed on the organic EL part 43. Part of the cathode 44 may be disposed on the substrate 41. The optimal value for the thickness of the cathode 44 is different depending on the material used and may be set in view of electric conductivity, durability, and so on. The thickness of the cathode 44 is usually from 10 nm to 10 µm, preferably from 20 nm to 1 µm, and more preferably from 50 nm to 500 nm.

It is preferable that a material for the cathode 44 is a material in which reflectance is high for the light (in particular, visible light) from the light-emitting layer that the organic EL part 43 has, such that light from the organic EL part 43 (specifically, light from the light-emitting layer) is reflected by the cathode 44 and then advances to the anode 42 side. Example of the material for the cathode 44 include alkali metals, alkali earth metals, transition metals, and group 13 metals in the periodic table. As the cathode 44, it is possible to use a transparent conductive electrode made of, for instance, a conductive metal oxide and conductive organic matter.

The cathode 44 may be formed by, for instance, the methods similar to the methods in the case of the anode 42. The cathode 44 may be formed by a lamination process in which a metal thin film is subjected to thermocompression bonding.

In the device base material forming step S10, the anode 42, the organic EL part 43, and the cathode 44 are sequentially layered on a plurality of device formation regions virtually set on the substrate 41 while the belt-shaped substrate 41 is conveyed in the longitudinal direction by a roll-to-roll method, so as to form a device base material 40. The size of each device formation region may be set to desired size (e.g., product size) of the organic EL device to be manufactured. The anode 42, the organic EL part 43, and the cathode 44 may be formed by the above-described methods. When the organic EL part 43 has a multilayer structure, the respective layers may be formed, in sequence, from the anode 42 side.

### [Preparation Step of Protective Film-attached Sealing Member]

During the preparation step S20 of the protective film-attached sealing member 10(hereinafter, referred to as preparation step S20), the protective film-attached sealing member 10 is dehydrated by a roll-to-roll method. As shown in FIG. 2, the preparation step S20 has an unwinding step S21, a dehydration step S22, and a winding step S23.

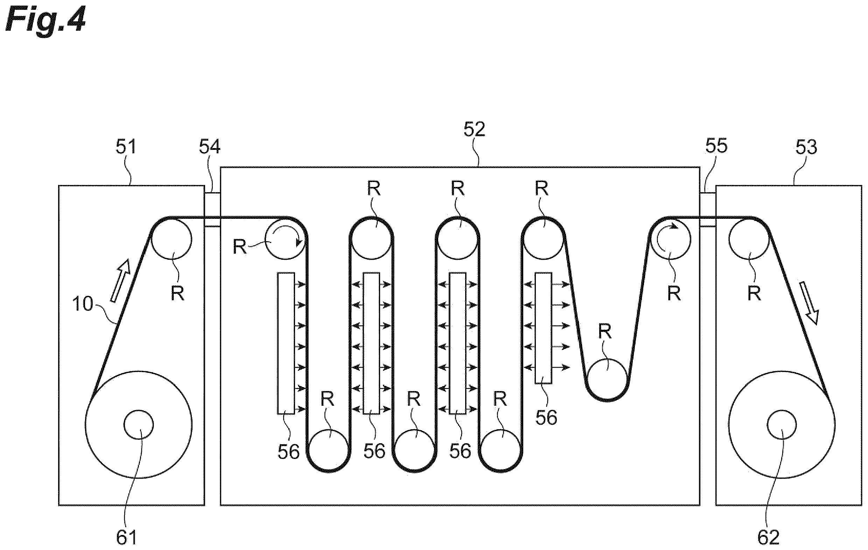

FIG. 4 is a diagram illustrating the preparation step S20 of the protective film-attached sealing member. In FIG. 4, the protective film-attached sealing member 10 is schematically depicted using a bold solid line. In the preparation step S20, the protective film-attached sealing member 10 is dehydrated while being conveyed in the longitudinal direction by using conveying rolls R. In this embodiment, the protective film-attached sealing member 10 is conveyed while the protective film 30 is in contact with each conveying roll R. However, the resin film 23 may be in contact with each conveying roll R.

### (Unwinding Step)

In the unwinding step S21, as shown in FIG. 4, the roll-shaped protective film-attached sealing member 10 is set at an unwinding unit 61 arranged in an unwinding chamber 51, and the protective film-attached sealing member 10 is then unwound. The unwound protective film-attached sealing member 10 is conveyed to a heating chamber 52 by using the conveying roll R. The unwinding chamber 51 and the heating chamber 52 may be connected with a connecting part 54 or may be directly connected.

### (Dehydration Step)

In the dehydration step S22, the protective film-attached sealing member 10 having been conveyed from the unwinding chamber 51 is dehydrated while being conveyed using each conveying roll R. The dehydration process is not limited and, in this embodiment, unless otherwise indicated, described is an embodiment where the protective film-attached sealing member 10 is heated for dehydration (thermal dehydration) by utilizing infrared radiation. Specifically, in the dehydration step S22 of this embodiment, the protective film-attached sealing member 10 is subjected to thermal dehydration by irradiating the protective film-attached sealing member 10 with infrared radiation from infrared irradiation units 56 arranged on a conveyance route of the protective film-attached sealing member 10.

Each infrared irradiation unit 56 has a configuration in which infrared radiation used for thermal dehydration can be output. Each infrared irradiation unit 56 is, for instance, an infrared radiation heater. Each infrared irradiation unit 56 may be arranged with respect to the protective film-attached sealing member 10 such that the protective film-attached sealing member 10 is irradiated with infrared radiation from, for instance, the protective film 30 side.

The infrared radiation with which the protective film-attached sealing member 10 is irradiated is preferably mid-infrared light (at a wavelength of from 1.8 µm to 3.0 µm) including water absorption wavelengths so as to efficiently heat and dehydrate the protective film-attached sealing member 10. The heating temperature (the surface temperature of the protective film-attached sealing member 10) and/or the heating duration during the dehydration step S22 are adjustable in accordance with a member used in the protective film-attached sealing member 10.

### (Winding Step)

In the winding step S23, the protective film-attached sealing member 10 having been heated and dehydrated in the heating chamber 52 is wound, like a roll, by using a winding unit 62 in a winding chamber 53 arranged rearwardly of the heating chamber 52. In the winding chamber 53, the protective film-attached sealing member 10 having been conveyed from the heating chamber 52 is conveyed to the winding unit 62 using the conveying roll R. The heating chamber 52 and the winding chamber 53 may be connected with a connecting part 55, or they may be directly connected.

### [Sealing Member Bonding Step]

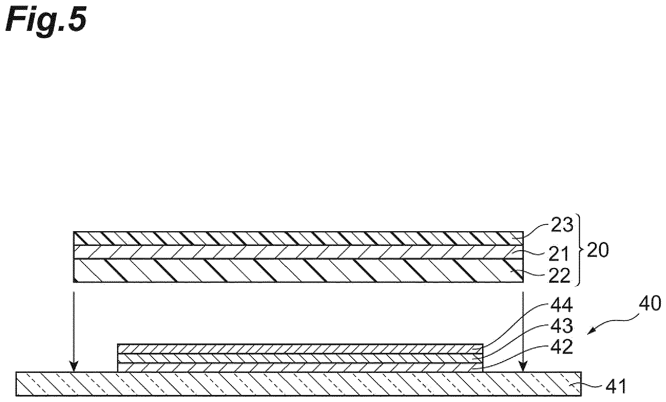

In the sealing member bonding step S30, the protective film 30 is peeled from the protective film-attached sealing member 10 that has been subjected to the dehydration step S22; and as shown in FIG. 5, the sealing member 20 is bonded via the adhesive layer 22 to the device base material 40 to produce an organic EL device. The sealing member bonding step S30 can be carried out by a roll-to-roll method while the protective film-attached sealing member 10 and the device base material 40 are each conveyed in the longitudinal direction.

Specifically, the heated and dehydrated, roll-shaped, protective film-attached sealing member 10 is set at an unwinding unit arranged in an unwinding chamber of the protective film-attached sealing member 10 for the sealing member bonding step S30. Subsequently, the protective film-attached sealing member 10 is unwound, and the protective film 30 is peeled continuously from the protective film-attached sealing member 10 while being conveyed in the longitudinal direction.

Next, while being conveyed in the longitudinal direction, the sealing member 20 obtained by peeling the protective film 30 from the protective film-attached sealing member 10 is continuously bonded to the device base material 40 being conveyed in the longitudinal direction. Specifically, the sealing member 20 is bonded to the device base material 40 by pressurizing and heating the sealing member 20 and the device base material 40 in the thickness direction while the adhesive layer 22 of the sealing member 20 faces the device base material 40 as shown in FIG. 5.

The device base material 40 being conveyed in the longitudinal direction may be a device base material 40 that has been continuously conveyed subsequently after forming the cathode 44 in the device base material forming step S10. Alternatively, the device base material 40 being conveyed in the longitudinal direction may be a device base material 40 that has been unwound after setting the device base material 40, once rolled up after forming the cathode 44, at an unwinding unit for the device base material 40.

In FIGS. 3 and 5, the device base material 40 is simplified and schematically depicted. The anode 42 and the cathode 44 may each be configured such that a part of each of the anode 42 and the cathode 44 can be drawn from the sealing member 20 so as to be able to apply voltage to the anode 42 and the cathode 44. Alternatively, the anode 42 and the cathode 44 may be formed to electrically connect to corresponding electrode parts by forming, on the substrate 41, the electrode parts disposed corresponding to the respective anode 42 and cathode 44, portions of the electrode parts being arranged outside the sealing member 20.

An organic EL device per device formation region is formed after the sealing member bonding step S30. Thus, the method for manufacturing an organic EL device may include an individualization step of making the substrate 41 that has been subjected to the sealing member bonding step S30 into an individual piece per device formation region. In the individualization step, the substrate 41 is split per device formation region to produce organic EL devices with desired size (e.g., product size).

The above method for manufacturing an organic EL device has the dehydration step S22, so that moisture in the sealing member 20 can be removed to bond the sealing member 20 to the device base material 40. Hence, favorable sealing performance can be achieved, and it is possible to suppress deterioration due to moisture of the organic layer in the organic EL device.

In an embodiment where the adhesive layer 22 contains a desiccant, in the organic EL device manufactured, it is possible to further prevent infiltration of water into the organic layer in the organic EL device.

In an embodiment where the thermal dehydration is carried out using infrared radiation in the dehydration step S22, moisture in the protective film-attached sealing member 10, in particular, in the adhesive layer 22 can be directly heated by utilizing infrared radiation, so that the protective film-attached sealing member 10 can be efficiently dehydrated. Further, use of infrared radiation makes it easy to perform the dehydration step S22 while the protective film-attached sealing member 10 is being conveyed. Hence, the time required for the dehydration step S22 can be shortened, and as a result, productivity of the organic EL device can be improved.

In the method for manufacturing an organic EL device according to this embodiment, the protective film-attached sealing member 10 is dehydrated, so that the preparation step S20 can be carried out while the protective film-attached sealing member 10 is conveyed using the conveying rolls R. Further, the preparation step S can be carried out while attachment of dust, etc., to the adhesive layer 22 is prevented.

In an embodiment where the thickness of the protective film 30 is 50 µm or less, moisture released from, for instance, the adhesive layer 22 in the dehydration step S22 is likely to be released through the protective film 30 to the outside of the protective film-attached sealing member 10. Accordingly, the protective film-attached sealing member 10 can be efficiently dehydrated while occurrence of bubbles between the protective film 30 and the adhesive layer 22 is suppressed. When the protective film 30 is too thin, it is difficult to handle and/or may be damaged. Consequently, the thickness of the protective film 30 is, for instance, 7 µm or more. In an embodiment, the thickness of the protective film 30 is equal to or more than 7 µm and equal to or less than 25 µm.

The peel strength of the adhesive layer 22 to the protective film 30 in the protective film-attached sealing member 10 used in the method for manufacturing an organic EL device according to this embodiment is from 0.06 N/20 mm to 0.3 N/20 mm.

If the above peel strength is 0.06 N/20 mm or more, bubbles caused by moisture release from the adhesive layer 22 are unlikely to substantially occur between the protective film 30 and the adhesive layer 22 during the dehydration step S22. This makes it possible to prevent deformation of the protective film-attached sealing member 10 such as deformation of the sealing base 21 or peeling of the protective film 30 due to the bubbles. If the above peel strength is 0.3 N/20 mm or less, peeling marks do not substantially occur on the surface of the adhesive layer 22 (a surface of the adhesive layer 22 on the protective film 30 side) when the protective film 30 is peeled from the adhesive layer 22 during the sealing member bonding step S30. As a result, deformation of the sealing base material 21 due to peeling marks does not occur.

As described above, that the peel strength of the adhesive layer 22 to the protective film 30 is from 0.06 N/20 mm to 0.3 N/20 mm makes it possible to prevent deformation of the protective film-attached sealing member 10 due to the bubbles as well as to prevent peeling marks when the protective film 30 is peeled from the adhesive layer 22. This makes it possible to bond the sealing member 20 to the device base material 40 in a desired state and to prevent bubbles from being mixed in a bonding portion between the sealing member 20 and the device base material 40. As a result, in the organic EL device manufactured, it is possible to suppress infiltration of water from, for instance, the sealing member 20 into the organic layer, thereby achieving favorable sealing performance.

In an embodiment where the thickness of the protective film 30 is, for instance, equal to or more than 7 µm and equal to or less than 25 µm as mentioned above, moisture released from the adhesive layer 22 is more unlikely to be released through the protective film 30 to the outside of the protective film-attached sealing member 10 than in the case where the thickness of the protective film 30 is less than 7 µm. In this case, a gap between the protective film 30 and the sealing base material 21 occurs and bubbles are thus likely to occur. By contrast, when the peel strength of the adhesive layer 22 to the protective film 30 is 0.06 N/20 mm or higher, bubbles caused by moisture release from the adhesive layer 22 are unlikely to substantially occur between the protective film 30 and the adhesive layer 22 during the dehydration step S22. When the peel strength of the adhesive layer 22 to the protective film 30 is 0.3 N/20 mm or less or further 0.18 N/20 mm or less, peeling marks do not substantially occur on the surface of the adhesive layer 22 (a surface of the adhesive layer 22 on the protective film 30 side) even if the protective film 30 is peeled from the adhesive layer 22.

In an embodiment where a material for the sealing base material 21 contains aluminum, the sealing base material 21 is vulnerable to deformation due to the influence of bubbling and/or peeling marks if bubbles occur in the dehydration step S22. Hence, the method for manufacturing an organic EL device as illustrated in this embodiment is more effective in the case where the material for the sealing base material 21 is aluminum.

Next, Experimental Example 1, Experimental Example 2, Comparative Experimental Example 1, and Comparative Experimental Example 2, in which effects on the peel strength of the adhesive layer 22 to the protective film 30 are examined, will be described. To avoid repetition, components of the Experimental example and the Comparative experimental example corresponding to the components of the above description will be denoted by the same reference signs.

### [Experimental Example 1]

In Experimental Example 1, a protective film-attached sealing member 10, which had been cut into a 10 cm-square piece, was prepared. The protective film-attached sealing member 10 included the sealing base material 21, the adhesive layer 22, and the protective film 30.

The sealing base material 21 was copper foil (CF-T8G-STD-35, manufactured by FUKUDA METAL FOIL & POWDER CO., LTD.) with a thickness of 35 µm. The adhesive layer 22 was a sticky layer using a pressure-sensitive adhesive. The thickness of the adhesive layer 22 was 30 µm. The thickness of the protective film 30 was 25 µm. A coating layer containing a silicone resin-based release agent is formed on a surface of the protective film 30 on the adhesive layer 22 side.

The protective film-attached sealing member 10 was manufactured by preparing a sealing member 20, in which the adhesive layer 22 was layered on the sealing base material 21, and then bonding the protective film 30 onto an adhesive layer 22 surface on a side opposite to the sealing base material 21. The bonding of the protective film 30 to the adhesive layer 22 was carried out by heating the adhesive layer 22 and the protective film 30 at 80°C for 30 sec under a vacuum environment at 0.5 MPa.

The peel strength of the adhesive layer 22 to the protective film 30 in the prepared protective film-attached sealing member 10 was 0.18 N/20 mm. The peel strength of a test piece was measured by using a light load-type adhesive / film peeling analyzer VPA-3S, manufactured by Kyowa Interface Science, Co., Ltd. in accordance with JIS Z0237. The test piece with a width of 20 mm had the same configuration and was manufactured under the same manufacturing conditions as the prepared protective film-attached sealing member 10. The peel rate at the time of the peel strength measurement was 50 mm/min.

The prepared protective film-attached sealing member 10 was irradiated in vacuum (at 1 × 10⁻⁵ Pa) with infrared radiation to heat and dehydrate the protective film-attached sealing member 10 at 160°C. As a result, any bubbles did not occur between the protective film 30 and the adhesive layer 22.

The protective film-attached sealing member 10 was heated and dehydrated as described above, and the protective film 30 was then peeled from the adhesive layer 22. The surface of the adhesive layer 22 peeled from the protective film 30 was visually inspected, and as a result, peeling marks did not occur.

### [Experimental Example 2]

In Experimental Example 2, a protective film-attached sealing member 10 having the same configuration as in Experimental Example 1 was used, except that the peel strength of the adhesive layer 22 to the protective film 30 was 0.06 N/20 mm. In Experimental Example 2, a coating layer containing a silicone resin-based release agent was still used. The peel strength was adjusted by changing the structure of material for the coating layer, that was formed on a protective film 30 surface on the adhesive layer 22 side, containing a silicone resin-based release agent. The peel strength was measured under the same conditions as in Experimental Example 1, except for using a test piece with a width of 20 mm having the same configuration and being manufactured under the same manufacturing conditions as the protective film-attached sealing member 10 prepared in Experimental Example 2.

In Experimental Example 2, the prepared protective film-attached sealing member 10 was heated and dehydrated under the same conditions as in Experimental Example 1. As a result, any bubbles between the protective film 30 and the adhesive layer 22 did not occur at the time of thermal dehydration in Experimental Example 2.

The protective film-attached sealing member 10 was heated and dehydrated as described above, and the protective film 30 was then peeled from the adhesive layer 22. The surface of the adhesive layer 22 peeled from the protective film 30 was visually inspected, and as a result, peeling marks did not occur.

### [Comparative Experimental Example 1]

In Comparative Experimental Example 1, a protective film-attached sealing member 10 having the same configuration as in Experimental Example 1 was used, except that the peel strength of the adhesive layer 22 to the protective film 30 was 0.35 N/20 mm. In Comparative Experimental Example 1, a coating layer containing a silicone resin-based release agent was still used. The peel strength was adjusted by changing the structure of material for the coating layer, that was formed on a protective film 30 surface on the adhesive layer 22 side, containing a silicone resin-based release agent. The peel strength was measured under substantially the same conditions as in Experimental Example 1, except for using a test piece with a width of 20 mm having the same configuration and being manufactured under the same manufacturing conditions as the protective film-attached sealing member 10 prepared in Comparative Experimental Example 1.

In Comparative Experimental Example 1, the prepared protective film-attached sealing member 10 was heated and dehydrated under the same conditions as in Experimental Example 1. As a result, in Comparative Experimental Example 1, any bubbles between the protective film 30 and the adhesive layer 22 did not occur at the time of thermal dehydration.

The protective film-attached sealing member 10 was heated and dehydrated as described above, and the protective film 30 was then peeled from the adhesive layer 22. The surface of the adhesive layer 22 from which the protective film 30 was peeled was visually inspected, and as a result, peeling marks occurred.

### [Comparative Experimental Example 2]

In Comparative Experimental Example 2, a protective film-attached sealing member 10 having the same configuration as in Experimental Example 1 was used, except that the peel strength of the adhesive layer 22 to the protective film 30 was 0.02 N/20 mm. In Comparative Experimental Example 2, a coating layer containing a silicone resin-based release agent was still used. The peel strength was adjusted by changing the structure of material for the coating layer, that was formed on a protective film 30 surface on the adhesive layer 22 side, containing a silicone resin-based release agent. The peel strength was measured under the same conditions as in Experimental Example 1, except for using a test piece with a width of 20 mm having the same configuration and being manufactured under the same manufacturing conditions as the protective film-attached sealing member 10 prepared in Comparative Experimental Example 2.

In Comparative Experimental Example 2, the prepared protective film-attached sealing member 10 was heated and dehydrated under the same conditions as in Experimental Example 1. As a result, in Comparative Experimental Example 2, bubbles between the protective film 30 and the adhesive layer 22 occurred at the time of thermal dehydration.

The protective film-attached sealing member 10 was heated and dehydrated as described above, and the protective film 30 was then peeled from the adhesive layer 22. The surface of the adhesive layer 22 from which the protective film 30 was peeled was visually inspected, and as a result, roughness due to bubbling marks occurred.

The experimental results of thermal dehydration of the protective film-attached sealing members 10 in the above Experimental Example 1, Experimental Example 2, Comparative Experimental Example 1, and Comparative Experimental Example 2 have demonstrated that when the peel strength of the adhesive layer 22 to the protective film 30 ranges from 0.06 N/20 mm to 0.3 N/20 mm, occurrence of bubbles during dehydration can be prevented and peeling marks do not occur when the protective film 30 is peeled from the adhesive layer 22.

Hereinabove, various embodiments of the invention have been described. However, the invention is not necessarily limited to the above-described various embodiments, and a variety of modifications are allowed without departing from the spirit of the invention.

The case where the protective film-attached sealing member has a belt shape has been described. However, the protective film-attached sealing member may have a sheet shape. Likewise, the device base material (or a substrate that the device base material has) may have a sheet shape.

The preparation step of the protective film-attached sealing member including the unwinding step and the winding step has been described. However, the preparation step of the protective film-attached sealing member does not necessarily include at least one of the unwinding step or the winding step.

In the dehydration step S22 shown in FIG. 2, the case where the protective film-attached sealing member is heated and dehydrated using infrared radiation has been described. However, the procedure for dehydrating the protective film-attached sealing member is not restricted to the procedure using infrared radiation. For instance, a procedure for dehydrating the protective film-attached sealing member by blowing hot wind may be implemented.

The organic EL device manufactured by the organic EL device manufacturing method is not limited to a form of emitting light from the substrate side, and is applicable to organic EL devices in which light is emitted from a side opposite to the substrate. The configuration where the first electrode and the second electrode of the device base material are an anode and a cathode, respectively, has been described, but the first electrode may be a cathode and the second electrode may be an anode. The invention is also applicable to organic electronic devices other than organic EL devices, such as organic solar cells, organic photodetectors, and/or organic transistors.

### Reference Signs List

- 10: Protective film-attached sealing member
- 20: Sealing member
- 21: Sealing base material
- 22: Adhesive layer
- 23: Resin film
- 30: Protective film
- 40: Device base material
- 41: Substrate
- 42: Anode (First electrode)
- 43: Organic EL part (Organic layer-containing device function part)
- 44: Cathode (Second electrode)
- 56: Infrared irradiation unit

## Claims

1. A method for manufacturing an organic electronic device, comprising:
a device base material forming step of forming a device base material in which a first electrode, an organic layer-containing device function part, and a second electrode are sequentially provided on a substrate;
a dehydration step of dehydrating a protective film-attached sealing member in which a protective film is layered, via an adhesive layer, on a sealing member having the adhesive layer layered on a sealing base material; and
a sealing member bonding step of bonding the sealing member via the adhesive layer to the device base material after the protective film is peeled from the protective film-attached sealing member having been subjected to the dehydration step, wherein
a peel strength of the adhesive layer to the protective film in the protective film-attached sealing member is from 0.06 N/20 mm to 0.3 N/20 mm.

2. The method for manufacturing an organic electronic device according to claim 1,
wherein in the dehydration step, the protective film-attached sealing member is dehydrated by irradiating the protective film-attached sealing member with infrared radiation.

3. The method for manufacturing an organic electronic device according to claim 1 or 2,
wherein the adhesive layer contains a desiccant.

4. The method for manufacturing an organic electronic device according to any one of claims 1 to 3,
wherein a thickness of the protective film is 50 µm or less.

5. The method for manufacturing an organic electronic device according to any one of claims 1 to 3,
wherein a thickness of the protective film is equal to or more than 7 µm and equal to or less than 25 µm, and
the peel strength is from 0.06 N/20 mm to 0.18 N/20 mm.

6. The method for manufacturing an organic electronic device according to any one of claims 1 to 5,
wherein a material for the sealing base material contains aluminum or copper.
